Europäisches Patentamt

European Patent Office

Office européen des brevets

(19)

(11) EP 0 499 673 B1

(12) **EUROPÄISCHE PATENTSCHRIFT**

(45) Veröffentlichungstag und Bekanntmachung des Hinweises auf die Patenterteilung:
**08.05.1996 Patentblatt 1996/19**

(51) Int Cl.$^6$: **G05F 3/20**, G11C 5/14

(21) Anmeldenummer: **91102555.9**

(22) Anmeldetag: **21.02.1991**

(54) **Regelschaltung für einen Substratvorspannungsgenerator**

Control circuit for a substrate bias generator

Circuit de commande pour un générateur de tension d'un substrat

(84) Benannte Vertragsstaaten:
**AT DE FR GB IT NL**

(43) Veröffentlichungstag der Anmeldung:
**26.08.1992 Patentblatt 1992/35**

(73) Patentinhaber: **SIEMENS AKTIENGESELLSCHAFT**
**D-80333 München (DE)**

(72) Erfinder:
• **Savignac, Dominique, Dr.**
**W-8045 Ismaning (DE)**
• **Menke, Manfred**
**W-8000 München 81 (DE)**
• **Gleis, Dieter, Dr.**
**W-8201 Grosskarolinenfeld (DE)**

(56) Entgegenhaltungen:
**GB-A- 2 149 251**

• **PATENT ABSTRACTS OF JAPAN, Band 6, Nr. 218 (E-139)[1096], 2. November 1982; & JP-A-57 121 269 (TOKYO SHIBAURA DENKI K.K.) 28-07-1982**
• **RESEARCH DISCLOSURE, Nr. 267, Juli 1986, Seite 379, Zusammenfassung Nr. 26705, Emsworth, Hampshire, GB; "CMOS hysteresis receiver"**
• **IBM TECHNICAL DISLCOSURE BULLETIN, Band 29, Nr. 3, August 1986, Seiten 1353- 1354, New York, US; "CMOS schmitt trigger buffer"**

**Beschreibung**

Die Erfindung betrifft eine Regelschaltung für einen Substratvorspannungsgenerator nach dem Oberbegriff des Patentanspruchs 1.

Bei modernen integrierten Halbleitschaltungen, insbesondere bei Halbleiterspeichern und Mikroprozessoren, wird das Substrat der Schaltung häufig mittels einer Substratvorspannung auf einem elektrischen Potential gehalten, das ungleich den üblichen Versorgungsspannungen VDD, VSS der Halbleiterschaltung ist. Diese wird dabei heutzutage nicht über einen Chip-anschluß von extern zugeführt (wie in der Vergangenheit meist üblich), sondern "on chip" mittels eines Substratvorspannungsgenerators erzeugt. Um die erzeugte Substratvorspannung VBB innerhalb der durch Bausteinspezifikation vorgegebenen Grenzen halten zu können, ist zur Regelung des Substratvorspannungsgenerators, und damit zur Regelung der Substratvorspannung VBB, eine Regelung vorgesehen.

Das Patent Abstract of Japan, Band 6, Nr. 218 (E-139) [1096], 2. November, 1982 zeigt einen Substratvorspannungsgenerator mit einer gattungsgemäßen Regelschaltung. Die Regelschaltung beinhaltet eine Schmitt-Trigger-Schaltung, welche im wesentlichen eine Reihenschaltung aus 3 Transistoren aufweist.

Aufgabe der vorliegenden Erfindung ist es, eine Regelschaltung der eingangs genannten Art zu schaffen mit möglichst wenig Schaltelementen und mit einem möglichst niedrigen Flächenbedarf.

Diese Aufgabe wird gelöst durch eine Regelschaltung mit den Merkmalen des Patentanspruchs 1.

Die erfindungsgemäße Schaltung reduziert in vorteilhafter Weise den über den Hysterese-Transistor fließenden Querstrom, da durch die Anordnung der ersten Inverteranordnung vor dem Gate des Hysteresetransistors ein die vollständige Sperrung des Transistors ermöglichender Spannungspegel an dessen Gate anliegt, sobald die untere Schaltschwelle der ersten Inverteranordnung - je nach Leitungstyp des Hysteresetransistors und der Realisierung der ersten Inverteranordnung - unter-bzw. überschritten wird. Weitere Verluste bzw. ungünstige Beeinflussungen der Substratvorspannung werden dadurch vermindert, daß die erste Inverteranordnung für eine größere Flankensteilheit des Ansteuerungssignals für das Gate des Hysteresetransistors sorgt, so daß dieser (und somit die gesamte Schmitt-Trigger-Schaltung) sehr kurze Schaltzeiten aufweist.

Vorteilhafte Aus- und Weiterbildungen sind in Unteransprüchen gekennzeichnet.

Die Erfindung wird nachstehend anhand der Figuren näher erläutert. Es zeigen:

Die Figuren 1,10 bis 12 vorteilhafte Ausgestaltungen der Erfindung,
die Figuren 2 bis 9 vorteilhafte Einzelheiten und
Figur 13 ein Potentialdiagramm, das die Regelcharakteristik der Regelschaltung aufzeigt.

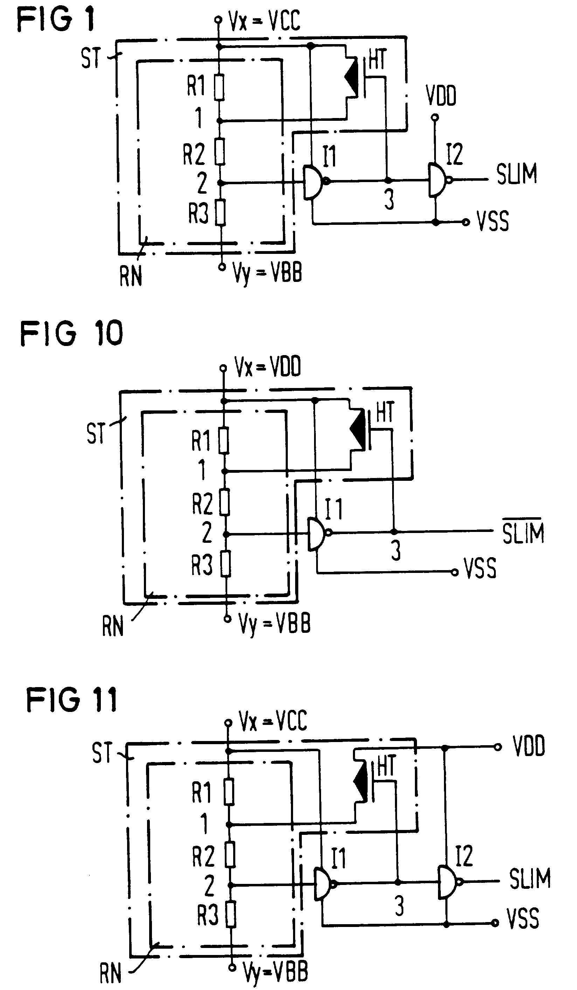

Figur 1 zeigt einen Anschluß für ein erstes Potential Vx einer Halbleiterschaltung, in der die Regelschaltung enthalten ist. Das erste Potential Vx kann das für eine Halbleiterschaltung übliche Versorgungspotential VDD sein (typischerweise 5 V; im folgenden als "zweites Versorgungspotential VDD" bezeichnet). Es kann jedoch auch ein geregeltes Potential VCC sein, das niedriger als das (zweite) Versorgungspotential VDD ist. Bei modernen integrierten Halbleiterspeichern als Halbleiterschaltung ist es aufgrund immer kleiner werdender Strukturen mittlerweile üblich, an die Halbleiterschaltung zwar das (bislang bereits übliche) Versorgungspotential VDD = 5 V extern anzulegen, chipintern (insbesondere für die Zellenfelder) jedoch ein aus dem (zweiten) Versorgungspotential VDD abgeleitetes geregeltes Potential VCC zu verwenden, das niedriger ist als das Versorgungspotential VDD (z.B. VCC = 3.3 V). Die Verwendung dieses geregelten Potentiales VCC hat den Vorteil, daß die Regelschaltung entkoppelt ist von eventuell auftretenden Schwankungen des Versorgungspotentials VDD, so daß im Betrieb eine genauere Regelung der Substratvorspannung VBB erfolgen kann. Die vom Substratvorspannungsgenerator (nicht dargestellt, da nicht Bestandteil der Erfindung) zu erzeugende Substratvorspannung VBB wird dadurch auch unabhängig vom Versorgungspotential VDD und seinen eventuell auftretenden Schwankungen.

Figur 1 zeigt weiterhin einen Anschluß für ein zweites Potential Vy. Dieses ist im allgemeinen gleich der Substratvorspannung VBB. In einer besonderen Ausführungsform der Erfindung, die noch erläutert wird, ist es jedoch gleich einem ersten Versorgungspotential VSS (meist als Masse bezeichnet, d.h. VSS = 0 V) der Halbleiterschaltung.

Zwischen den beiden Potentialen Vx,Vy ist eine Schmitt-Trigger-Schaltung ST angeordnet. Dieser ist ausgangsseitig eine erste Inverteranordnung I1 nachgeschaltet, die versorgungsspannungsmäßig mit dem ersten Potential Vx und dem ersten Versorgungspotential VSS verbunden ist.

Jede Schmitt-Trigger-Schaltung weist bekanntlich eine Hysterese in ihrem Schaltverhalten auf. Dazu wird ihr Eingang entsprechend beschaltet. Vorliegend ist zu diesem Zweck ihr Eingang mit dem Ausgang der ersten Inverteranordnung I1 verbunden.

Wesentliche Elemente der vorliegenden Schmitt-Trigger-Schaltung ST sind drei in Serie zueinander geschaltete Widerstandselemente R1,R2,R3 (Widerstandsnetzwerk RN), die, insgesamt betrachtet, zwischen den beiden Potentialen Vx,Vy angeordnet sind. Dabei entstehen zwischen dem ersten und dem zweiten Widerstandselement R1,R2 ein erster Schaltungsknoten 1 der Regelschaltung sowie zwischen dem zweiten und dem dritten Widerstandselement R2,R3 ein zweiter Schaltungsknoten 2 der Regelschaltung. In Figur 1 sind die Widerstandselemente R1,R2,R3 ohm'sche Widerstände.

Ein weiteres wesentliches Element der vorliegenden Schmitt-Trigger-Schaltung ST ist ein Hysterese-Transistor HT, der der Steuerung der Hysteresefunktion der Schmitt-Trigger-Schaltung ST dient. Er ist mit seiner Kanalstrecke dem ersten Widerstandselement R1 parallelgeschaltet, d.h. seine Kanalstrecke ist mit dem ersten Potential Vx und mit dem ersten Schaltungsknoten 1 verbunden. Sein Gate ist als Regeleingang der Schmitt-Trigger-Schaltung ST mit dem Ausgang der ersten Inverteranordnung I1, der einen dritten Schaltungsknoten 3 der Regelschaltung bildet, verbunden. In Figur 1 ist der Hysterese-Transistor vom p-Kanal-Typ. In einem solchen Fall enthält die erste Inverteranordnung I1 eine ungerade Anzahl von Invertern, d.h. mindestens einen Inverter. Das Vorsehen von mehr als einem Inverter bei der ersten Inverteranordnung I1 bewirkt einerseits ein Verstärken des an ihr auftretenden Eingangssignals und eine größere Flankensteilheit ihres Ausgangssignals, andererseits benötigt die Pegelschaltung jedoch mehr Fläche. Der Substratbereich des in Figur 1 dargestellten Hysterese-Transistors HT ist vorzugsweise ebenfalls mit dem ersten Potential Vx = VCC verbunden. Damit weist der Hysterese-Transistor HT eine niedrigere Einsatzspannung auf als bei Verbindung seines Substratbereiches mit dem zweiten Versorgungspotential VDD, da Vx < VDD.

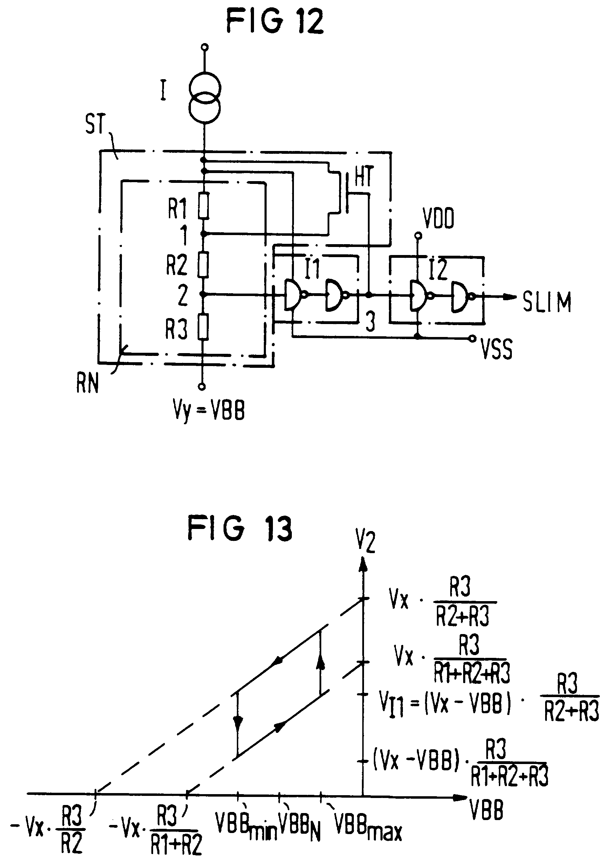

In Figur 1 ist der ersten Inverteranordnung I1 über den dritten Schaltungsknoten 3 noch eine zweite Inverteranordnung I2 nachgeschaltet. Sie enthält wenigstens einen Inverter, wie dargestellt. Die zweite Inverteranordnung I2 ist versorgungsspannungsmäßig mit den beiden Versorgungspotentialen VSS, VDD der Halbleiterschaltung verbunden. An ihrem Ausgang entsteht ein Steuersignal SLIM als Ausgangssignal der Regelschaltung, welches der Steuerung des Substratvorspannungsgenerators, der die Substratvorspannung VBB erzeugt, dient. Zum Betrieb der erfindungsgemäßen Regelschaltung ist die zweite Inverteranordnung I2 jedoch nicht zwingend notwendig; sie dient lediglich einer Verstärkung des am dritten Schaltungsknoten 3 anliegenden Signals. Bei Weglassen der zweiten Inverteranordnung I2 entsteht das Steuersignal SLIM (dann allerdings in anderer Phasenlage und mit einem anderen High-Pegel) bereits am dritten Schaltungsknoten 3 (vgl. Figur 10).

Nachstehend wird der Betrieb der Regelschaltung nach Figur 1 anhand des Potentialdiagramms von Figur 13 näher erläutert. Bei Anlegen der Versorgungspotentiale VSS, VDD an die Halbleiterschaltung wird zunächst das geregelte Potential VCC aufgebaut (nicht Bestandteil der Regelschaltung, deshalb nicht dargestellt), welches dann als erstes Potential Vx an der Regelschaltung anliegt. Die Substratvorspannung VBB liegt zunächst auf dem Wert des ersten Versorgungspotentials VSS; der Substratvorspannungsgenerator beginnt die (gegenüber den Versorgungspotentialen VSS, VDD negative) Substratvorspannung VBB aufzubauen. Der dritte Schaltungsknoten 3 liegt zunächst noch auf dem Wert des ersten Versorgungspotentials VSS, d.h. Masse. Der Hysterese-Transistor HT leitet demzufolge und schließt somit das erste Widerstandselement RI elektrisch kurz.

Wegen der Spannungsteilerwirkung des Widerstandsnetzwerkes RN liegt anfangs am zweiten Schaltungsknoten 2 also ein Potential $V_2 = Vx \cdot \frac{R3}{R2+R3}$ (die Substratvorspannung VBB wurde der Einfachheit halber weggelassen, da ihr Anfangswert noch ca. 0 V beträgt; korrekterweise müßte die Formel ansonsten lauten: $V_2 = (Vx - VBB) \cdot \frac{R3}{R2+R3}$). Da die Substratvorspannung VBB zunehmend negativer wird, sinkt das Potential $V_2$ am Schaltnngsknoten 2 ab (vgl. strichpunktierte Linie in Figur 13). Zunächst erreicht die Substratvorspannung VBB einen Wert $VBB_{max}$, den sie im Betrieb dann nicht mehr übersteigt. Zu diesem Zeitpunkt weist das Potential $V_2$ noch einen Wert auf, der oberhalb eines Wertes $V_{I1}$ liegt, der gleich ist der Spannung, bei dem die erste Inverteranordnung I1 ihren komplementären Zustand annimmt ("Umschaltpunkt"). Der dritte Schaltungsknoten 3 weist somit einen niedrigen Potentialzustand (= erstes Versorgungspotential VSS) auf, so daß das Steuersignal SLIM am Ausgang der Regelschaltung wegen der zweiten Inverteranordnung I2 einen hohen Potentialwert (= zweites Versorgungspotential VDD) aufweist, wodurch der Substratvorspannungsgenerator angenommenermaßen weiterhin in Betrieb bleibt. Damit wird die Substratvorspannung VBB immer negativer, so daß das Potential $V_2$ am zweiten Schaltungsknoten 2 weiter absinkt bis unter den Wert $V_{I1}$. Zu diesem Zeitpunkt weist die Substratvorspannung VBB einen Minimalwert $VBB_{min}$ auf, den sie im Betrieb nicht unterschreitet. Sobald das Potential " $V_2$ am zweiten Schaltungsknoten 2 den Wert $V_{I1}$ unterschreitet, - kippt die erste Inverteranordnung I1 in ihren komplementären Zustand, d.h. der dritte Schaltungsknoten 3 nimmt den Wert des ersten Potentials Vx an (die erste Inverteranordnung I1 ist versorgungsspannungsmäßig mit dem ersten Potential Vx verbunden).

Damit jedoch wird der Hysterese-Transistor HT gesperrt, das erste Widerstandselement RI wird wirksam, so daß das Potential $V_2$ am zweiten Schaltungsknoten 2 auf den Wert $(Vx - VBB) \cdot \frac{R3}{R1+R2+R3}$ absinkt. Da das Potential am dritten Schaltungsknoten 3, wie bereits angegeben, nunmehr den Wert des ersten Potentials Vx aufweist, weist entsprechend das Steuersignal SLIM wegen der zweiten Inverteranordnung I2 einen niedrigen Wert (= erstes Versorgungspotential VSS) auf. Damit jedoch wird der Substratvorspannungsgenerator abgeschaltet, d.h. die Substratvorspannung VBB wird nicht noch negativer.

Wegen in jeder Halbleiterschaltung auftretender Leckstromverluste bezüglich der Substratvorspannung VBB (beispielsweise besteht auch bei der vorliegenden Schaltung nach Figur 1 ein gewisser, von der Dimensionierung der Widerstandselemente RI, R2, R3 abhängiger Querstrom zwischen dem ersten Potential Vx und der Substratvorspannung VBB), die meist bis zu einem gewissen Umfang sogar erwünscht sind (z.B. kann er der Begrenzung der Substratvorspannung auf den Wert VBB$_{min}$ dienen), steigt die Substratvorspannung VBB nunmehr wiederum langsam an. Somit steigt auch das Potential V$_2$ am zweiten Schaltungsknoten 2 langsam an bis über den Wert V$_{l1}$, bei dem die erste Inverteranordnung I1 dann ihren ursprünglichen Zustand wieder annimmt, d.h. der dritte Schaltungsknoten I3 nimmt wieder seinen niedrigen Wert an (er ist typischerweise gleich dem Wert des ersten Versorgungspotentials VSS, d.h. 0 V). Zu diesem Zeitpunkt hat die Substratvorspannung VBB ihren Maximalwert VBB$_{max}$. Damit jedoch wird der Transistor T wieder leitend, so daß das Potential V$_2$ am zweiten Schaltungsknoten 2 den Wert von $(Vx - VBB) \cdot \frac{R3}{R2+R3}$ annimmt. Gleichzeitig nimmt das Steuersignal SLIM seinen hohen Wert (= VDD) an und schaltet somit den Substratvorspannungsgenerator wieder ein. Infolgedessen wird die Substratvorspannung VBB zunehmend negativer; der bereits beschriebene Vorgang beginnt von neuem. In Figur 13 ist der zeitliche Verlauf des Potentials V$_2$ am zweiten Schaltungsknoten 2 durch Pfeile angedeutet.

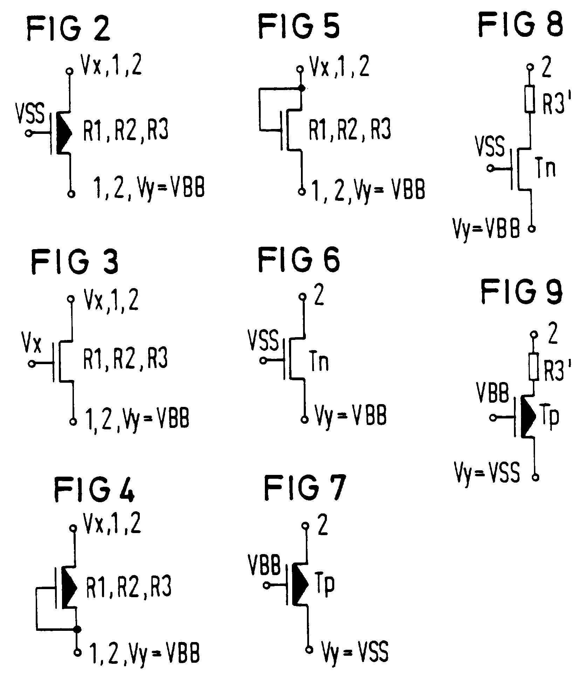

Gemäß den Figuren 2 und 4 können eines, mehrere oder alle Widerstandselemente R1,R2,R3 als p-Kanal-Transistoren aufgebaut sein, deren Sources mit dem ersten Potential Vx (R1), mit dem ersten Schaltungsknoten 1 (R2) oder mit dem zweiten Schaltungsknoten 2 (R3) verbunden sind und deren Drains mit dem ersten Schaltungsknoten 1 (R1), dem zweiten Schaltungsknoten 2 (R2) oder dem zweiten Potential Vy verbunden sind, wobei das zweite Potential Vy wiederum gleich der Substratvorspannung VBB ist. In der Ausführungsform nach Figur 2 ist das Gate mit dem ersten Versorgungspotential VSS verbunden, während bei der Ausführungsform nach Figur 4 das Gate mit der zugehörigen Drain verbunden ist.

Gemäß den Ausführungsformen nach den Figuren 3 und 5 können jedoch auch eines, mehrere oder alle Widerstandselemente R1,R2,R3 als n-Kanal-Transistoren aufgebaut sein, deren Drains mit dem ersten Potential Vx (R1), mit dem ersten Schaltungsknoten 1 (R2) oder mit dem zweiten Schaltungsknoten 2 (R3) verbunden sind und deren Sources mit dem ersten Schaltungsknoten 1 (R1), dem zweiten Schaltungsknoten 2 (R2) oder dem zweiten Potential Vy verbunden sind, wobei das zweite Potential Vy wiederum gleich der Substratvorspannung VBB ist. In der Ausführungsform nach Figur 3 ist das Gate mit dem ersten Potential Vx verbunden, während bei der Ausführungsform nach Figur 5 das Gate mit der zugehörigen Drain verbunden ist.

Nach Figur 6 ist das dritte Widerstandselement R3 ein n-Kanal-Transistor Tn, der auch in leitendem Zustand einen endlichen Widerstand aufweist. Er ist mit der Substratvorspannung VBB als zweitem Potential Vy verbunden. Das Gate dieses Transistors Tn ist mit dem ersten Versorgungspotential VSS verbunden.

Soll jedoch der zuvor bereits erwähnte Querstrom zwischen dem ersten Potential Vx und der Substratvorspannung VBB über das Widerstandsnetzwerk RN zum zweiten Potential Vy = VBB vermieden werden, so eignet sich dafür die Ausführungsform nach Figur 7 besonders: Nach Figur 7 dient als zweites Potential Vy nicht die Substratvorspannung VBB, sondern das erste Versorgungspotential VSS der Halbleiterschaltung. Als drittes Widerstandselement R3 ist ein p-Kanal-Transistor Tp vorgesehen, der in leitendem Zustand ebenfalls einen endlichen Widerstand aufweist. Sein Gate ist mit der Substratvorspannung VBB verbunden. Der Einfluß des jeweils aktuellen Wertes der Substratvorspannung VBB auf die Potentialverhältnisse am zweiten Schaltungsknoten 2 erfolgt hier also nicht, wie bei den zuvor bereits beschriebenen Ausführungsformen, über das zweite Potential Vy (das hier ja fest den Wert des ersten Versorgungspotentials VSS aufweist), sondern über das Gate des p-Kanal-Transistors Tp, d.h. über dessen jeweiliges Leitvermögen, das ja über das Gate steuerbar ist.

Die Figuren 8 und 9 zeigen die n- bzw. p-Kanal-Transistoren Tn, Tp nach den Figuren 6 und 7, ergänzt um jeweils ein weiteres Widerstandselement R', das zwischen diesen Transistoren Tn,Tp und dem zweiten Schaltungsknoten 2 angeordnet ist. Mit diesen Ausgestaltungen lassen sich die Potentialverhältnisse am jeweiligen zweiten Schaltungsknoten 2 leichter den Erfordernissen der Regelung, und damit der Regelschaltung, anpassen.

Die Ausführungsform nach Figur 10 unterscheidet sich von der Ausführungsform nach Figur 1 in zwei Punkten: Zum einen enthält sie keine zweite Inverteranordnung I2; das Steuersignal $\overline{\text{SLIM}}$ für den Substratvorspannungsgenerator entsteht bereits am dritten Schaltungsknoten 3. Es hat demzufolge gegenüber dem Steuersignal SLIM nach Figur 1 einen entgegengesetzten zeitlichen Verlauf, was aber beim Schaltverhalten des Substratvorspannungsgenerators leicht berücksichtigt werden kann.

Zum anderen hat das erste Potential Vx den Wert des zweiten Versorgungspotentials VDD der Halbleiterschaltung. Auch mit dieser Maßnahme funktioniert die erfindungsgemäße Regelschaltung. Allerdings ist bei Verwendung des zweiten Versorgungspotentials VDD anstelle einer geregelten Spannung VCC als erstes Potential Vx das Regelverhalten der Regelschaltung, und somit auch das Steuersignal $\overline{\text{SLIM}}$ und die Funktion des Substratvorspannungsgenerators, beeinflußt von den bei dem zweiten Versorgungspotential VDD üblicherweise auftretenden Schwankungen.

Die Ausführungsform nach Figur 11 unterscheidet sich von der nach Figur 1 nur insoweit, als die Source des Hysterese-Transistors HT nicht mit dem ersten Potential Vx = VCC verbunden ist, sondern mit dem zweiten Versorgungspotential VDD. Dies hat allerdings zum einen den in Figur 10 bereits geschilderten Nachteil und zum anderen ist der Hysterese-Transistor HT nie ganz gesperrt, da an seinem Gate über den dritten Schaltungsknoten 3 nie das zweite Versorgungspotential VDD anliegt, sondern maximal der Wert des ersten Potentials Vx = VCC mit VCC < VDD.

Bei der Ausführungsform nach Figur 12 wird anstelle des ersten Potentials Vx eine Konstantstromquelle I verwendet. Dies hat dieselben Vorteile wie die Verwendung eines geregelten Potentials VCC als erstes Potential (vgl. Figur 1). Der Hysterese-Transistor HT ist als n-Kanal-Transistor ausgeführt. Deshalb enthält die erste Inverteranordnung I1 eine gerade Anzahl hintereinander geschalteter Inverter; in Figur 12 sind zwei Stück dargestellt. Auch die zweite Inverteranordnung I2 enthält eine Hintereinanderschaltung von mehreren Invertern, vorliegend ebenfalls eine solche von zwei Invertern. Damit lassen sich am dritten Schaltungsknoten 3 und am Ausgang der Regelschaltung eine größere Flankensteilheit und ein verstärktes Potential (dritter Schaltungsknoten 3) bzw. ein verstärktes Steuersignal SLIM erreichen.

Die vorliegende Erfindung wurde beschrieben unter der Annahme, daß sie bei einer Halbleiterschaltung angewandt wird, deren Substratmaterial vom p-Typ ist. Sie ist jedoch auch anwendbar in Halbleiterschaltungen, deren Substratmaterial vom n-Typ ist. In einem solchen Fall ist die Substratvorspannung VBB das positivste aller angegebenen Potentiale. Dabei müssen lediglich die Polaritäten der angegebenen Potentiale vertauscht werden und auch die Leitungstypen bei den angegebenen Transistoren. Dies bereitet dem Fachmann jedoch keine Schwierigkeiten, da er die vorliegende Offenbarung anhand seines Fachwissens leicht entsprechend umsetzen kann.

**Patentansprüche**

1. Regelschaltung für einen Substratvorspannungsgenerator zur Erzeugung einer Substratvorspannung (VBB) in einer integrierten Halbleiterschaltung, welche eine Schmitt-Trigger-Schaltung (ST) aufweist, die zwischen einem ersten Potential (Vx) und einem zweiten Potential (Vy) der Halbleiterschaltung angeordnet ist, wobei die Schmitt-Trigger-Schaltung ein zwischen dem ersten (Vx) und dem zweiten Potential (Vy) angeordnetes Widerstandsnetzwerk (RN) mit wenigstens drei in Serie geschalteten Widerstandselementen (R1, R2, R3) sowie einen Hysteresetransistor (HT) zur Steuerung der Hysteresefunktion, dessen Gate der Eingang der Schmitt-Trigger-Schaltung (ST) ist, beinhaltet, wobei zwischen dem ersten Widerstandselement (R1) und dem zweiten Widerstandselement (R2) ein erster Schaltungsknoten (1) der Regelschaltung und zwischen dem zweiten Widerstandselement (R2) und dem dritten Widerstandselement (R3) ein zweiter Schaltungsknoten (2) der Regelschaltung entsteht,
**dadurch gekennzeichnet,**
daß der Schmitt-Trigger-Schaltung ST ausgangsseitig am zweiten Schaltungsknoten (2) eine erste Inverteranordnung (I1) nachgeschaltet ist, die versorgungsspannungsmäßig mit dem ersten Potential (Vx) und einem ersten Versorgungspotential (VSS) der Halbleiterschaltung verbunden ist, daß der Hysteresetransistor (HT) mit seiner Kanalstrecke zwischen dem ersten Potential (Vx) und dem ersten Schaltungsknoten (1) angeordnet ist und daß das Gate des Hysteresetransistors (HT) mit dem Ausgang der ersten Inverteranordnung (I1) verbunden ist.

2. Regelschaltung nach Anspruch 1, **dadurch gekennzeichnet,** daß der ersten Inverteranordnung (I1) eine zweite Inverteranordnung (I2) nachgeschaltet ist.

3. Regelschaltung nach Anspruch 2, **dadurch gekennzeichnet,** daß die zweite Inverteranordnung (I2) versorgungsspannungsmäßig mit dem ersten Versorgungspotential (VSS) und mit einem zweiten Versorgungspotential (VDD) der Halbleiterschaltung verbunden ist.

4. Regelschaltung nach einem der Ansprüche 1 bis 3, **dadurch gekennzeichnet,** daß das erste Potential (Vx) ein zweites Versorgungspotential (VDD) der Halbleiterschaltung ist.

5. Regelschaltung nach einem der Ansprüche 1 bis 3, **dadurch gekennzeichnet,** daß das erste Potential (Vx) ein geregeltes Potential (VCC) ist, das geringer ist als ein zweites Versorgungspotential (VDD) der Halbleiterschaltung.

6. Regelschaltung nach einem der vorhergehenden Ansprüche, **dadurch gekennzeichnet,** daß die Schmitt-Trigger-Schaltung (ST) ein Widerstandsnetzwerk (RN) mit wenigstens drei in Serie zueinander angeordneten Widerstandselementen (R1,R2,R3) enthält, das zwischen dem ersten (Vx) und dem zweiten Potential (Vy) angeordnet ist, wobei zwischen dem ersten Widerstandselement (RI) und dem zweiten Widerstandselement (R2) ein erster Schaltungsknoten (1) der Regelschaltung entsteht und wobei zwischen dem zweiten Widerstandselement (R2) und dem dritten Widerstandselement (R3) ein zweiter Schaltungsknoten (2) der Regelschaltung entsteht.

7. Regelschaltung nach Anspruch 6, **dadurch gekennzeichnet,** daß wenigstens eines der Widerstandselemente (R1,R2,R3) in Transistorschaltung aufgebaut ist.

8. Regelschaltung nach Anspruch 7, **dadurch gekennzeichnet,** daß wenigstens eines der als Transistoren geschalteten Widerstandselemente (R1,R2,R3) vom p-Kanaltyp ist, dessen Gate mit dem ersten Versorgungspotential (VSS) verbunden ist.

9. Regelschaltung nach Anspruch 7 oder 8, **dadurch gekennzeichnet,** daß wenigstens eines der als Transistoren geschalteten Widerstandselemente (R1,R2,R3) vom n-Kanaltyp ist, dessen Gate mit dem ersten Potential (Vx) verbunden ist.

10. Regelschaltung nach Anspruch 7, 8 oder 9, **dadurch gekennzeichnet,** daß bei wenigstens einem der als-Transistoren geschalteten Widerstandselemente (R1,R2,R3) das Gate mit dessen Drain verbunden ist.

11. Regelschaltung nach einem der Ansprüche 6 bis 10, **dadurch gekennzeichnet,** daß wenigstens eines der Widerstandselemente (R1,R2,R3) ein ohm'scher Widerstand ist.

12. Regelschaltung nach einem der vorhergehenden Ansprüche, **dadurch gekennzeichnet,** daß das zweite Potential (Vy) die Substratvorspannung (VBB) ist.

13. Regelschaltung nach einem der Ansprüche 6 bis 12, **dadurch gekennzeichnet,** daß das dritte Widerstandselement (R3) ein n-Kanal-Transistor (Tn) ist, dessen Gate mit dem ersten Versorgungspotential (VSS) verbunden ist.

14. Regelschaltung nach einem der Ansprüche 6 bis 11, **dadurch gekennzeichnet,** daß das zweite Potential (Vy) das erste Versorgungspotential (VSS) ist und daß das dritte Widerstandselement (R3) ein p-Kanal-Transistor (Tp) ist, dessen Gate mit der Substratvorspannung (VBB) verbunden ist.

15. Regelschaltung nach Anspruch 13 oder 14, **dadurch gekennzeichnet,** daß zwischen dem zweiten Schaltungsknoten (2) und dem dritten Widerstandselement (R3) wenigstens ein weiteres Widerstandselement (R') angeordnet ist.

16. Regelschaltung nach einem der Ansprüche 6 bis 15, **dadurch gekennzeichnet,** daß zur Steuerung der Hysteresefunktion ein Hysterese-Transistor (HT) vorgesehen ist, dessen Gate der Eingang der Schmitt-Trigger-Schaltung (ST) ist.

17. Regelschaltung nach Anspruch 16, **dadurch gekennzeichnet,** daß der Hysterese-Transistor (HT) mit seiner Kanalstrecke zwischen dem ersten Potential (Vx) und dem ersten Schaltungsknoten (1) angeordnet ist.

18. Regelschaltung nach Anspruch 16, **dadurch gekennzeichnet,** daß der Hysterese-Transistor (HT) mit seiner Kanalstrecke zwischen dem zweiten Versorgungspotential (VDD) und dem ersten Schaltungsknoten (1) angeordnet ist.

19. Regelschaltung nach Anspruch 17 oder 18, **dadurch gekennzeichnet,** daß der Hysterese-Transistor (HT) in gesperrtem Zustand als erstes Widerstandselement (R1) mit einem endlichen Widerstandswert dient.

20. Regelschaltung nach einem der Ansprüche 16 bis 19, **dadurch gekennzeichnet,** daß die erste Inverteranordnung (I1) eine ungerade Anzahl von Invertern enthält, wenn der Hysterese-Transistor (HT) vom p-Kanaltyp ist und ansonsten eine gerade Anzahl von Invertern.

21. Regelschaltung nach einem der vorhergehenden Ansprüche, **dadurch gekennzeichnet,** daß die zweite Inverteranordnung (I2) wenigstens einen Inverter enthält.

22. Regelschaltung nach einem der vorhergehenden Ansprüche, **dadurch gekennzeichnet,** daß das erste Potential (Vx) durch eine Konstantstromquelle (I) ersetzt ist.

**Claims**

1. Control circuit for a substrate bias generator for producing a substrate bias (VBB) in an integrated semiconductor circuit, which control circuit has a Schmitt trigger circuit (ST) which is disposed between a first potential (Vx) and a second potential (Vy) of the semiconductor circuit, the Schmitt trigger circuit containing a resistor network (RN) disposed between the first (Vx) and the second potential (Vy) and comprising at least three series-connected resistance elements (R1, R2, R3), and containing a hysteresis transistor (HT) for controlling the hysteresis function whose gate is the input of the Schmitt trigger circuit (ST), a first circuit node (1) of the control circuit being formed between the first resistance element (R1) and the second resistance element (R2) and a second circuit node (2) of the control circuit being formed between the second resistance element (R2) and the third resistance element (R3), characterized in that there is connected downstream of the Schmitt trigger circuit (ST) on the output side at the second circuit node (2) a first inverter arrangement (I1) which is connected in terms of supply voltage to the first potential (Vx) and a first supply potential (VSS) of the semiconductor circuit, in that the channel section of the hysteresis transistor (HT) is disposed between the first potential (Vx) and the first circuit node (1), and in that the gate of the hysteresis transistor (HT) is connected to the output of the first inverter arrangement (I1).

2. Control circuit according to Claim 1, characterized in that a second inverter arrangement (I2) is connected downstream of the first inverter arrangement (I1).

3. Control circuit according to Claim 2, characterized in that the second inverter arrangement (I2) is connected in terms of supply voltage to the first supply potential (VSS) and to a second supply potential (VDD) of the semiconductor circuit.

4. Control circuit according to one of Claims 1 to 3, characterized in that the first potential (Vx) is a second supply potential (VDD) of the semiconductor circuit.

5. Control circuit according to one of Claims 1 to 3, characterized in that the first potential (Vx) is a control potential (VCC) which is less than a second supply potential (VDD) of the semiconductor circuit.

6. Control circuit according to one of the preceding claims, characterized in that the Schmitt trigger circuit (ST) contains a resistance network (RN) which contains at least three resistance elements (R1, R2, R3) arranged in series with one another and which is disposed between the first (Vx) and the second potential (Vy), a first circuit node (1) of the control circuit being formed between the first resistance element (R1) and the second resistance element (R2) and a second circuit node (2) of the control circuit being formed between the second resistance element (R2) and the third resistance element (R3).

7. Control circuit according to Claim 6, characterized in that at least one of the resistance elements (R1, R2, R3) is formed in transistor circuitry.

8. Control circuit according to Claim 7, characterized in that at least one of the resistance elements (R1, R2, R3) connected as transistors is of the p-channel type, whose gate is connected with the first supply potential (VSS).

9. Control circuit according to Claim 7 or 8, characterized in that at least one of the resistance elements (R1, R2, R3) connected as transistors is of the n-channel type, whose gate is connected to the first potential (Vx).

10. Control circuit according to Claim 7, 8 or 9, characterized in that, in the case of at least one of the resistance elements (R1, R2, R3) connected as transistors, the gate is connected to its drain.

11. Control circuit according to one of Claims 6 to 10, characterized in that at least one of the resistance elements (R1, R2, R3) is an ohmic resistor.

12. Control circuit according to one of the preceding claims, characterized in that the second potential (Vy) is the substrate bias (VBB).

13. Control circuit according to one of Claims 6 to 12, characterized in that the third resistance element (R3) is an n-channel transistor (Tn) whose gate is connected to the first supply potential (VSS).

14. Control circuit according to one of Claims 6 to 11, characterized in that the second potential (Vy) is the first supply potential (VSS) and in that the third resistance element (R3) is a p-channel transistor (Tp), whose gate is connected to the substrate bias (VBB).

15. Control circuit according to Claim 13 or 14, characterized in that at least a further resistance element (R') is disposed between the second circuit node (2) and the third resistance element (R3).

16. Control circuit according to one of Claims 6 to 15, characterized in that, to control the hysteresis function, a hysteresis transistor (HT) is provided whose gate is the input of the Schmitt trigger circuit (ST).

17. Control circuit according to Claim 16, characterized in that the channel section of the hysteresis transistor (HT) is disposed between the first potential (Vx) and the first circuit node (1).

18. Control circuit according to Claim 16, characterized in that the channel section of the hysteresis transistor (HT) is disposed between the second supply potential (VDD) and the first circuit node (1).

19. Control circuit according to Claim 17 or 18, characterized in that the hysteresis transistor (HT) serves in the off state as first resistance element (R1) having a finite resistance value.

20. Control circuit according to one of Claims 16 to 19, characterized in that the first inverter arrangement (I1) contains an uneven number of inverters if the hysteresis transistor (HT) is of the p-channel type and it otherwise contains an even number of inverters.

21. Control circuit according to one of the preceding claims, characterized in that the second inverter arrangement (I2) contains at least one inverter.

22. Control circuit according to one of the preceding claims, characterized in that the first potential (Vx) is replaced by a constant current source (I).

**Revendications**

1. Circuit de régulation d'un générateur de tension de polarisation d'un substrat destiné à produire une tension (VBB) de polarisation d'un substrat dans un circuit intégré à semiconducteur, qui comporte un circuit (ST) de trigger de Schmitt, disposé entre un premier potentiel (Vx) et un second potentiel (Vy) du circuit à semiconducteur, le circuit de trigger de Schmitt comprenant un réseau (RN) de résistances qui est disposé entre le premier (Vx) et le second (Vy) potentiel et qui comporte au moins trois éléments (R1, R2, R3) de résistance branchés en série, ainsi qu'un transistor (HT) d'hystérésis, qui est destiné à commander la fonction d'hystérésis et dont la grille est l'entrée du circuit (ST) de trigger de Schmitt, un premier noeud (1) du circuit de régulation apparaissant entre le premier élément (Rl) de résistance et le deuxième élément (R2) de résistance et un second noeud (2) du circuit de régulation apparaissant entre le second élément (R2) de résistance et le troisième élément (R3) de résistance,
caractérisé en ce que
un premier dispositif (l1) inverseur, qui est relié du point de vue tension d'alimentation au premier potentiel (Vx) et à un premier potentiel d'alimentation (VSS) du circuit à semiconducteur, est branché en aval du circuit (ST) de trigger de Schmitt du côté sortie au second noeud (2) du circuit, le transistor (HT) d'hystérésis est disposé par sa voie de canal entre le premier potentiel (Vx) et le premier noeud (1) du circuit et la grille du transistor (HT) d'hystérésis est reliée à la sortie du premier dispositif (l1) inverseur.

2. Circuit de régulation suivant la revendication 1, caractérisé en ce qu'un second dispositif (l2) inverseur est branché en aval du premier dispositif inverseur (l1).

3. Circuit de régulation suivant la revendication 2, caractérisé en ce que le second dispositif inverseur (l2) est relié du point de vue tension d'alimentation au premier potentiel (VSS) d'alimentation et à un second potentiel (VDD) d'alimentation du circuit à semiconducteur.

4. Circuit de régulation suivant l'une des revendications 1 à 3, caractérisé en ce que le premier potentiel (Vx) est un second potentiel (VDD) d'alimentation du circuit à semiconducteur.

5. Circuit de régulation suivant l'une des revendications 1 à 3, caractérisé en ce que le premier potentiel (Vx) est un potentiel (VCC) régulé, qui est plus petit qu'un second potentiel (VDD) d'alimentation du circuit à semiconducteur.

6. Circuit de régulation suivant l'une des revendications précédentes, caractérisé en ce que le circuit (ST) de trigger de Schmitt comprend un réseau (RN) de résistances, qui comporte au moins trois éléments (R1, R2, R3) de résistance disposés en série les uns avec les autres et qui est disposé entre le premier potentiel (Vx) et le second potentiel (Vy), un premier noeud (1) du circuit de régulation apparaissant entre le premier élément (R1) de résistance et le deuxième élément (R2) de résistance, et un second noeud (2) du circuit de régulation apparaissant entre le deuxième élément (R2) de résistance et le troisième élément (R3) de résistance.

7. Circuit de régulation suivant la revendication 6, caractérisé en ce qu'au moins l'un des éléments (R1, R2, R3) de résistance est formé dans le circuit à transistors.

8. Circuit de régulation suivant la revendication 7, caractérisé en ce qu'au moins l'un des éléments (R1, R2, R3) de résistance branchés comme transistors est du type à canal p dont la grille est reliée au premier potentiel (VSS) d'alimentation.

9. Circuit de régulation suivant la revendication 7 ou 8, caractérisé en ce qu'au moins l'un des éléments (R1, R2, R3) de résistance branchés comme transistors est du type à canal n dont la grille est reliée au premier potentiel (Vx).

10. Circuit de régulation suivant la revendication 7, 8 ou 9, caractérisé en ce que dans au moins l'un des éléments (R1, R2, R3) de résistance branchés comme transistors la grille est reliée au drain.

11. Circuit de régulation suivant l'une des revendications 6 à 10, caractérisé en ce qu'au moins l'un des éléments (R1, R2, R3) de résistance est une résistance ohmique.

12. Circuit de régulation suivant l'une des revendications précédentes, caractérisé en ce que le second potentiel (Vy) est la tension (VBB) de polarisation du substrat.

13. Circuit de régulation suivant l'une des revendications 6 à 12, caractérisé en ce que le troisième élément (R3) de résistance est un transistor (Tn) à canal n, dont la grille est reliée au premier potentiel (VSS) d'alimentation.

14. Circuit de régulation suivant l'une des revendications 6 à 11, caractérisé en ce que le second potentiel (Vy) est le premier potentiel (VSS) d'alimentation et le troisième élément (R3) de résistance est un transistor (Tp) à canal p, dont la grille est reliée à la tension de polarisation du substrat.

15. Circuit de régulation suivant la revendication 13 ou 14, caractérisé en ce qu'au moins un autre élément (R') de résistance est disposé entre le second noeud (2) de circuit et le troisième élément (R3) de résistance.

16. Circuit de régulation suivant l'une des revendications 6 à 15, caractérisé en ce qu'un transistor (HT) d'hystérésis, dont la grille est l'entrée du circuit (ST) de trigger de Schmitt, est prévu pour la commande de la fonction d'hystérésis.

17. Circuit de régulation suivant la revendication 16, caractérisé en ce que la voie de canal du transistor (HT) d'hystérésis est disposée entre le premier potentiel (Vx) et le premier noeud (1) de circuit.

18. Circuit de régulation suivant la revendication 16, caractérisé en ce que la voie de canal du transistor (HT) d'hystérésis est disposée entre le second potentiel (VDD) d'alimentation et le premier noeud (1) de circuit.

19. Circuit de régulation suivant la revendication 17 ou 18, caractérisé en ce que le transistor (HT) d'hystérésis sert dans l'état bloqué de premier élément (R1) de résistance ayant une valeur de résistance finie.

20. Circuit de régulation suivant la revendication 16 à 19, caractérisé en ce que le premier dispositif (I1) inverseur comprend un nombre impair d'inverseurs, si le transistor (HT) d'hystérésis est du type à canal p et comprend sinon un nombre pair d'inverseurs.

21. Circuit de régulation suivant l'une des revendications précédentes, caractérisé en ce que le second dispositif (I2) inverseur comprend au moins un inverseur.

22. Circuit de régulation suivant l'une des revendications précédentes, caractérisé en ce que le premier potentiel (Vx) est remplacé par une source (I) de courant constant.

**FIG 1**

**FIG 10**

**FIG 11**

FIG 2

Vx,1,2

VSS

R1,R2,R3

1,2,Vy=VBB

FIG 3

Vx,1,2

Vx

R1,R2,R3

1,2,Vy=VBB

FIG 4

Vx,1,2

R1,R2,R3

1,2,Vy=VBB

FIG 5

Vx,1,2

R1,R2,R3

1,2,Vy=VBB

FIG 6

2

VSS

Tn

Vy=VBB

FIG 7

2

VBB

Tp

Vy=VSS

FIG 8

2

R3'

VSS

Tn

Vy=VBB

FIG 9

2

R3'

VBB

Tp

Vy=VSS

# FIG 12

# FIG 13

$$Vx \cdot \frac{R3}{R2+R3}$$

$$Vx \cdot \frac{R3}{R1+R2+R3}$$

$$V_{I1} = (Vx - VBB) \cdot \frac{R3}{R2+R3}$$

$$(Vx - VBB) \cdot \frac{R3}{R1+R2+R3}$$

$$-Vx \cdot \frac{R3}{R2} \qquad -Vx \cdot \frac{R3}{R1+R2} \qquad VBB_{min} \quad VBB_N \quad VBB_{max}$$